Europäisches Patentamt

European Patent Office

Office européen des brevets

(19)

(11) Publication number: **0 299 639**

**A2**

(12) **EUROPEAN PATENT APPLICATION**

(21) Application number: **88305815.8**

(22) Date of filing: **27.06.88**

(51) Int. Cl.⁴: **H03M 5/18 , //H04L25/49**

(30) Priority: **13.07.87 US 72829**

(43) Date of publication of application:
**18.01.89 Bulletin 89/03**

(84) Designated Contracting States:
**BE CH DE FR GB IT LI LU NL SE**

(71) Applicant: **DAVID SYSTEMS, INC.**
**701 East Evelyn Avenue**
**Sunnyvale California 94086(US)**

(72) Inventor: **Cafiero, Luca**
**720 Seale Avenue**
**Palo Alto California 94303(US)**
Inventor: **Mazzola, Mario**
**5008 Peach Terrace**
**Campbell California 95008(US)**

(74) Representative: **Wright, Hugh Ronald et al**
**Brookes & Martin High Holborn House 52/54**
**High Holborn**
**London WC1V 6SE(GB)**

(54) **Digital data communications system.**

(57) A modulation method and apparatus is provided which can coexist with conventional Manchester (Ethernet) coding schemes and which can be transmitted and received over twisted pair cabling. The method according to the invention is a three-level D.C.-free code without bipolar violations wherein intersymbol interference is sufficiently controllable that the received signal can be detected as a two-level code. The code has a different power spectrum than Manchester coding for the same baud rate. The modulation method is a modified frequency modulation (Miller) code comprising three levels wherein each of the transitions is of a limited duration and the transition returns to zero d.c. after a predetermined pulse duration. The modulation method may be termed pulsed modified frequency modulation or pulsed Miller encoding. The signal so modulated is intended to be transmitted over twisted pair cabling of limited bandwidth such that the cabling serves as a low-pass filter. The pulsed modified frequency modulation encoding method according to the invention produces a fundamental at a frequency which is about half of the fundamental of a Manchester coding scheme at the same bit rate.

EP 0 299 639 A2

## DIGITAL DATA COMMUNICATIONS SYSTEM

### Background of the Invention

The present invention relates to digital communications and more particularly to digital communications using a modulation technique suitable for transmission of digital data over measurable lengths of standard telephone twisted pair cabling. The invention has primary application in local digital communication systems capable of supporting transmission rates of up to about 30 megabits per second over standard twisted pair cabling of length of less than about one thousand meters.

In the past, the transmission of information in digital form and at frequencies exceeding a few megabits per second has generally been accomplished by means of expensive cabling systems, such as coaxial cable, shielded data-grade twisted pair cable, or fiber optic cable. The use of standard voice-grade unshielded twisted pair cable has so far been limited either to bit rates of a few megabits per second over distances not exceeding a few thousand feet or to multimegabit per second communication over distances not exceeding a few hundred feet. One of the concerns of transmission of information at relatively high transmission rates and distances over standard twisted pairs is electromagnetic radiation. In order to be usable and practical, electromagnetic radiation must be limited, and the quality of the signals must qualify under well-established industry standards.

One of the popular and well-established local area net protocols is the Ethernet, which is now established as a standard under IEEE Standard 802.3. Various substandards of this protocol are also in popular use. The transmission rate of many Ethernet systems is now in the range of ten megabits per second with a maximum run length between repeaters of about 500 meters. The advantages offered by the Ethernet local area net system are well-known in the industry. However, one of the biggest drawbacks of an Ethernet system is the recommended use of coaxial cable as a transmission medium.

A suggested alternative to the cabling scheme Ethernet, as well as for most local area nets used in medium to large office environments is a wiring scheme based on voice-grade twisted pair cabling following conventional star topology wired to a central telephone distribution panel in a telephone wiring closet. Ideally, previously-installed twisted pair cabling could be used to connect voice circuits such as telephone to a private branch exchange or to a central telephone system switch while at the same time used to provide transmission of very high speed digital data.

Unfortunately, there are many difficult technical problems to be overcome in order to make standard twisted pair cabling a viable solution for simultaneous usage of voice and data over such a cabling system. First of all, voice grade standard twisted pair is a notoriously dispersive medium, which at frequencies exceeding about four megabits per second makes it difficult to meet stringent radiation standards defined for radio frequency interference and electromagnetic interference.

Second, communications protocols in most local area networks have been designed assuming very robust transmission media which easily provide bit error rates equal to or greater than $10^{-9}$. (Bit errors per bits transmitted). However, standard twisted pair cabling is generally not considered sufficient to support such a stringent bit error rate using known modulation schemes. It is therefore one of the purposes of this invention to provide a modulation scheme which compensates for deficiencies in standard twisted pair cabling transmission media.

Among the deficiencies of standard twisted pair cabling and data rates on the order of ten megabits per second over hundreds of meters are the following: Attenuation, cross-talk, low immunity to external noise sources, and distortion.

Attenuation is a result of signal dissipation between the source and destination of a signal. There is a trade-off between signal strength and interference caused by signal overload on the cable.

Cross-talk, both far-end cross-talk and near-end cross-talk are significant problems. Cross-talk results from electromagnetic coupling between adjacent cables, and is particularly acute when the signal strength through one cable is great in comparison to the signal strength on other cables. Hence, cross-talk is the major problem in the presence of significant signal attenuation. The use of standard twisted pair cabling at transmission rates in the range of ten megabits per second can pose serious radiation problems, resulting in cross-talk, if the same data coding techniques used in conjunction with conventional coaxial cabling or fiber optics are adopted with a twisted pair cabling. More specifically, the conventional Ethernet coding technique is the Manchester coding technique which provides that the peak energy spectrum be at about 7.5 MHz, corresponding to the average fundamental. The peak energy spectrum varies as a function of the bit pattern. Because of this peak energy spectrum, if such a coding technique is used on a twisted pair, higher order harmonics can easily cause radiation in frequency regions and at energy levels which would cause acute interference with adjacent cabling or even equipment external to the cabling environment. Another problem is that the Ethernet coding protocol includes in its signal a D.C. pedestal signal to simplify collision detection in its carrier sense collision detection protocol. Hence, the media employing conventional Ethernet coding techniques is typically limited to a dedicated application.

Another class of problems in connection with twisted pair cabling is noise. Three major types of noise must be taken into consideration: intersymbol interference noise, cross-talk noise and impulse noise. In the prior art, two techniques have been used to minimize intersymbol interference. The first technique is to equalize the received signal. The second technique is based on the predistortion of the transmitted signal with the purpose of emphasizing high frequency components of the signal, since the higher frequency components are those which will experience the stronger attenuation. These techniques are not suited to a networking system with twisted pairs supporting signals at relatively high frequency since these techniques are for the most part marginally effective and can compromise compliance with radiation limitations.

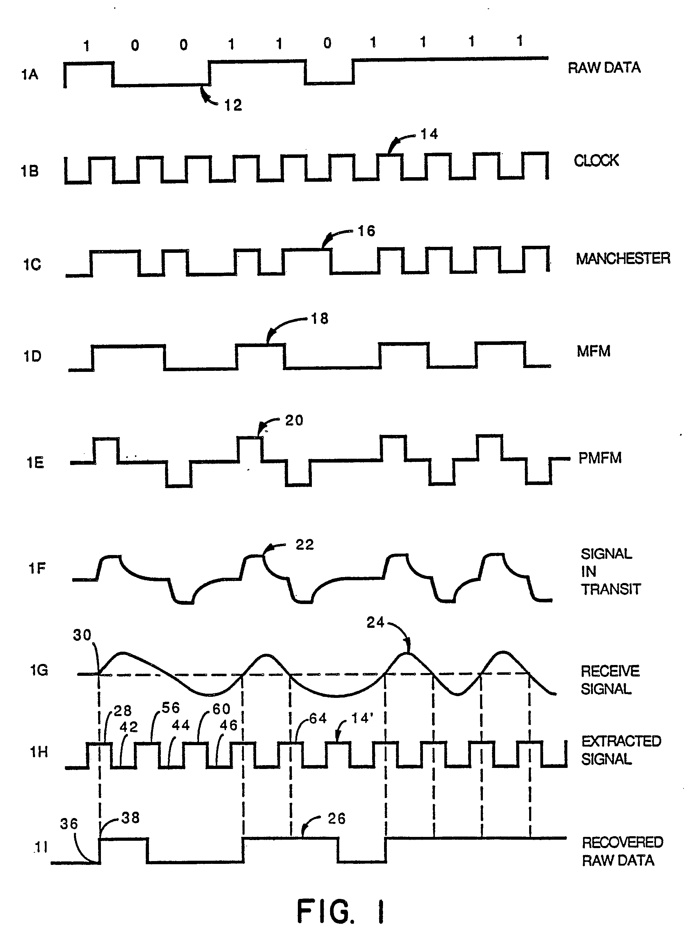

Another concern to be solved in a network communication is the need to provide compatibility with exiting local area network standards and practical installation issues. In standard Ethernet schemes, the use of the D.C. pedestal signal for collision detection is employed, whereas over standard twisted pair wiring, it is strongly advisable to transmit signal streams which are not only D.C. balanced but also D.C. free. Much prior art exists with respect to D.C.-free coding in both magnetic media and in transmission media. Of particular interest in connection with the present invention is the so-called modified frequency modulation code or Miller Code illustrated in one example in Figure 1 hereinbelow.

Another coding scheme, used in Ethernet, is the Manchester code. Neither of these codes are suitable in a hybrid environment, namely a local area network in which Manchester-coded signals must coexist with signals on closely adjacent twisted pairs. Nevertheless, it is necessary that the networking system used by the user appear to be transparent. These and other problems have been addressed and overcome in developing the present invention.

The present invention is to be distinguished from certain well-known prior art, such as the conventional DS-1 or DS-2 format (T-1 or T-2) pulse code modulation (PCM) method used in trunk communications. Such methods are distinguishable from the present invention in that it employs alternate mark invert (AMI) modulation requiring bipolar violations for clock synchronization. Conventional AMI modulation and encoding methods require extra self-clocking pulses and exhibit a broader spectral characteristic than the present invention.

The applicants are aware of the following published references which are believed to represent the state of the art in this field. U.S. Patent No. 3,108,261 issued Oct. 23, 1963 to A. Miller describes the modified frequency modulation code which has come to be known as the Miller code. The present invention is an adaptation of this encoding scheme to a three-level code with minimal charge accumulation.

U.S. Patent No. 3,810,111 issued May 7, 1974 to A.M. Patel and A.M. Patel's paper published in July 1975 in the IBM Journal of Research and Development pages 365-378 describe theory and application of the class of codes known as run length limited codes. The present invention is a type of run length limited code, but which is a D.C.-free code.

U.S. Patent No. 4,027,335 issued May 31, 1977 and U.S. Patent No. 4,234,897 issued Nov. 18, 1980 both to J.W. Miller describe D.C.-free codes which are improvements on modified Miller code. The codes described therein are two-level codes. There is a limited amount of instantaneous charge accumulation.

U.S. Patent No. 3,995,264 issued Nov. 30, 1976 to Ouchi describes a type of run length limited code of the class known as NRZ (non return to zero). This patent describes a two-level code which is an improvement over Patel U.S. Patent No. 3,810,111. This code experiences some instantaneous charge accumulation.

The present invention provides in a digital data communication system having a transmitter, a receiver and a communications medium, a method for modulating signals applied to said communications medium comprising the steps of:

converting a stream of binary digital data to a string of a modified frequency modulated code;

producing a pulse for each transition of said modified frequency modulation code, each said pulse having the same polarity as said transition of said modified frequency modulation code, wherein the length of each said pulse is a constant, to produce a string of pulses alternating about a zero reference; and

applying said string of pulses to a communicans medium.

The present invention also provides The method according to claim 1 wherein each said pulse has a maximum pulse length not exceeding the length of the minimum time between transitions of a modified frequency modulation signal.

We will describe a modulation method is provided which can coexist with conventional Manchester (Ethernet) coding schemes and which can be transmitted and received over twisted pair cabling. The method is a three-level D.C.-free code without bipolar violations wherein intersymbol interference is sufficiently controllable that the received signal can be detected as a two-level code. The code has a different power spectrum than Manchester coding for the same baud rate. The modulation method is a modified frequency modulation (Miller) code comprising three levels wherein each of the transitions is of a limited duration and the transition returns to zero d.c. after a predetermined pulse duration. The modulation method may be termed pulsed modified frequency modulation or pulsed Miller encoding. The signal so modulated is intended to be transmitted over twisted pair cabling of limited bandwidth such that the cabling serves as a low-pass filter. An apparatus to be described comprises a digital communication adapter including a first port for coupling directly to a conventional local area network such as an Ethernet, at least one twisted pair cabling port which supports communication using a modulation method in accordance with the invention. The pulsed modified frequency modulation encoding method produces a fundamental at a frequency which is about half of the fundamental of a Manchester coding scheme at the same bit rate. Still further, according to the invention, a collision carrier signal the collision carrier signal being a sinusoidal signal introduced in connection with the transmission of each block or packet of information to be transmitted, which collision signal can be used by receiving stations to detect the presence of data and to detect collisions in accordance with the Ethernet protocol.

An encoding scheme which provides a relatively narrow frequency spectrum concentrated at frequencies much lower than the bit rate not only provides lowered attenuation at the receiving end but also shows much less severe intersymbol interference and much greater near-end cross-talk immunity on adjacent wiring pairs in the presence of other signals at the same bit rate, such as conventional Ethernet signals employing Manchester coding techniques.

One of the characteristics of the coding and modulation scheme is D.C.-free transmission, absence of bipolar violations, and self-clocking detection, in addition to controllable intersymbol interference. The decoding and encoding of the signal is both fast and simple.

The invention will be better understood by reference to the following detailed description in connection with the accompanying drawings.

## Brief Description of the Drawings

Figure 1A is a timing diagram illustrating raw data.

Figure 1B is a timing diagram illustrating a clock signal.

Figure 1C is a timing diagram illustrating a Manchester code of the prior art corresponding with the raw data and showing a conventional Ethernet modulation, which may cause interference with modulation according to the present invention.

Figure 1D is a timing diagram illustrating modulation according to the modified frequency modulation encoding scheme, or Miller Code.

Figure 1E is a timing diagram illustrating modulation in accordance with the present invention.

Figure 1F is a timing diagram illustrating a first low-pass filtered version of the coding scheme according to the invention.

Figure 1G is a timing diagram illustrating a second low-pass filtered version of the modulation according to the invention.

Figure 1H is a timing diagram illustrating the detection windows in accordance with the invention.

Figure 1I is a timing diagram illustrating the signal recovered using the window scheme of Figure 1H and corresponds precisely to the transmitted coding scheme of Figure 1A.

Figure 2 is a frequency diagram illustrating the power spectrum of the coding scheme in accordance with the invention.

Figure 3 is a state diagram illustrating the detection method useful for detection of signals in accordance with the invention.

Figure 4 is a block diagram illustrating a circuit for encoding and decoding a signal in accordance with the invention.

Figure 5 is a schematic diagram of an encoder in accordance with the invention.

## Description of Specific Embodiments

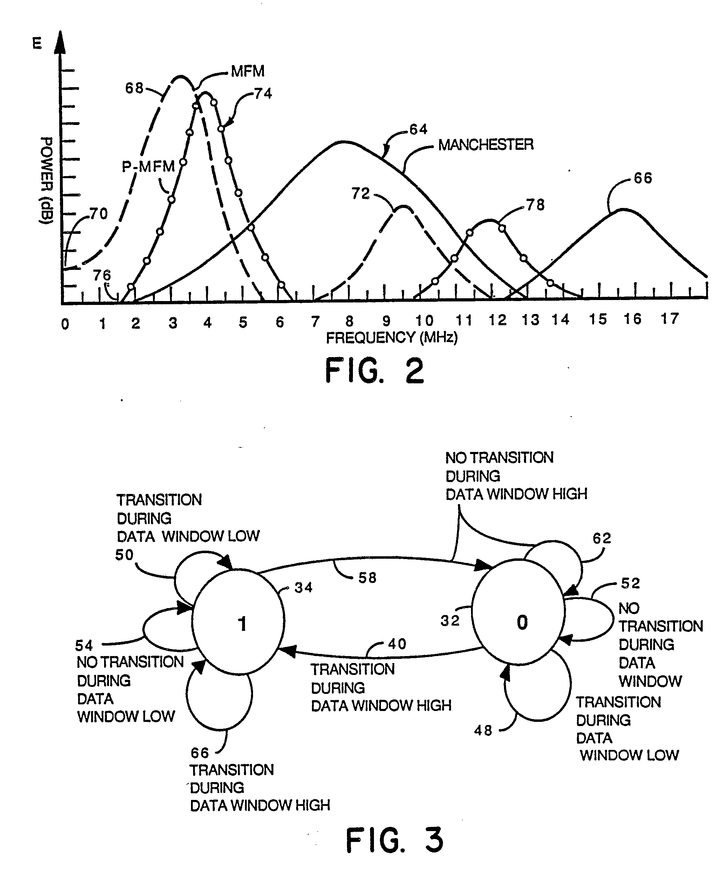

Referring to Figure 1, there is shown a set of timing diagrams for illustrating the modulation method used in the code in accordance with the invention. Specifically, Figure 1A is a timing diagram illustrating a raw data signal 12 comprising the binary string or bit stream 1001101111. This binary string contains an example of all allowable codes in accordance with the invention, as explained hereinbelow. Figure 1B is a timing diagram of a clock signal 14 associated with the raw data signal 12. In accordance with the invention, a synchronous clock signal 14' (Figure 1H) of the form of the clock signal 14 (Figure 1B) can be extracted from an encoded signal for use in recovering the raw data 12 (Figure 1A). A clock cycle consists of the time between two positive-going transitions. Figure 1C is a timing diagram illustrating a conventional Manchester encoded signal 16 corresponding to the raw data signal 12 as produced at the output of a conventional Manchester encoder of the prior art. The coding rules of this two-level signal are well known. The present invention produces a code which is nearly orthogonal to the Manchester code, as illustrated and explained in connection with Figure 2.

Figure 1D illustrates a timing diagram of a Miller (MFM) code signal 18 for the raw data signal 12. The MFM code is advantageous because it exhibits a practical maximum efficiency of 1. There are certain combinations of allowable state durations in accordance with MFM encoding, namely blocks of 1, 1-1/2, and 2 clock lengths. However, as is well-known, this two-level code has an undesirable D.C. component.

In accordance with the present invention, it is desirable to retain the efficiency and certain spectral characteristics of the MFM code as seen at a receiver, while at the same time minimizing the D.C. component and providing a modulated signal which is substantially orthogonal with a Manchester-coded signal. One of the purposes of the present invention is to minimize interference between Manchester-coded signals and one or more signals encoded and modulated in accordance with the present invention.

Figure 1E is a timing diagram illustrating the modulation of a signal 20 encoded in accordance with the invention. It will be observed that the encoding rules of the inventive signal 20 correspond with the rules of a conventional MFM signal 18, modified as follows: Each MFM transition generates a pulse of the same polarity as a corresponding MFM transition. The length of time for each pulse is a constant. More specifically, the maximum pulse length cannot exceed the length of the minimum time allotted for an MFM transition. Control of the length of the pulse provides for control of intersymbol interference, which in turn is a variable used in connection with the detection scheme. For this reason, the present invention is termed "pulsed modified frequency modulation" or PMFM or pulsed Miller code.

The signal in accordance with the invention is generated as a three-level code within a transmitter. However, in accordance with the invention, the reception of the signal is controlled in such a way that the received signal can be decoded by a conventional two-level MFM decoder. Figure 1F is a timing diagram illustrating the in transit signal 22 generated by a PMFM encoder in accordance with the invention as seen at some point along a communications media between the transmitter and the receiver. The in transit signal manifests the effects of a restricted passband, which may be a characteristic of the communications medium or which may be induced by a low-pass filter through which the PMFM signal 20 has passed.

Figure 1G is a timing diagram illustrating the received signal 24 as seen at the input of a conventional MFM decoder. In accordance with the invention, sufficient intersymbol interference has been induced to eliminate the effects of the intermediate level of the PMFM three-level code. In other words, in accordance with the invention, the communications medium, including any added low-pass filters, is employed to convert the three-level PMFM code of the invention to a signal which can be detected as if if were a two-level MFM code. It should be understood that the invention applies to many variances of the MFM code, such as the $M^2FM$ variance, and the variances imposing pre- and post-transition compensation on the MFM code. The received signal 24 is a synchronous signal wherein the clock signal 14′ is triggered and recovered from the received signal 24. A phase-locked loop oscillator is often used to reconstruct the clock signal 14′ from a few indicia in the signal, such as initial zero crossing. A phase-locked loop detection scheme of this type is conventional technology, but it is believed that such a detection scheme had not been contemplated for a signal which originated as a three-level code.

Referring to the state diagram of Figure 3 and Figures 1G, 1H and 1I, the recovered raw data signal 26 (Figure 1I) is derived as follows: The clock is initiated with its first data window high 28 at the first transition or zero crossing 30. From an initial state of zero 32 (at point 36), a transition 30 during data window high 28 will determine the change of state 40 from the zero state 32 to the one state 34 (at point 38). During any data window low period, i.e. 42, 44, 46, the presence or absence of a transition is ignored, as indicated explicitly by quasi state changes 48, 50, 52, 54, specifying all conditions during data window low periods. When in the one state 34 and if there is no transition during data window high 56, there is a change of state 58 to the zero state 32. Similarly, when in the zero state 32 and if there is no transition during data window high 60, there is no change of state, as indicated by quasi change of state 62. When in the one state 34 and if there is a transition during data window high 64, there is no change of state as indicated by quasi change of state 66. Thus, all state changes and quasi changes of state defining the recovery of the raw data are shown in Figure 3.

Figure 2 is a frequency diagram illustrating the power spectrum of the coding scheme in accordance with the invention in comparison with other coding and modulation techniques. A Manchester code power spectrum 64 centered at about 8 MHz is shown for reference. The Manchester code power spectrum 64 approaches zero power at above 1 MHz at the low frequency side and near about 12 MHz at the high frequency side with a side lobe 66 corresponding to the second harmonic. The standard MFM power spectrum 68 for the same data rate is centered at about 3.5 MHz, but has a D.C. component 70 (since it is not a D.C.-free code) and a side lobe 72 at the third harmonic of about 10.5 MHz. The standard MFM power spectrum 68 is substantially orthogonal to the Manchester code power spectrum 64, since the power of each is concentrated in different portions of the spectrum. However, the D.C. component 70 makes the MFM code undesirable in many applications.

According to the invention, the PMFM power spectrum 74 has a peak at about half the frequency as the peak of of the Manchester code power spectrum 64, while at the same time having no substantial power below a null 76 above about 1 MHz and moreover no D.C. component. The PMFM power spectrum 74 has a side lobe 78 at a third harmonic of its main lobe. Thus, the PMFM code is also substantially orthogonal to the Manchester code.

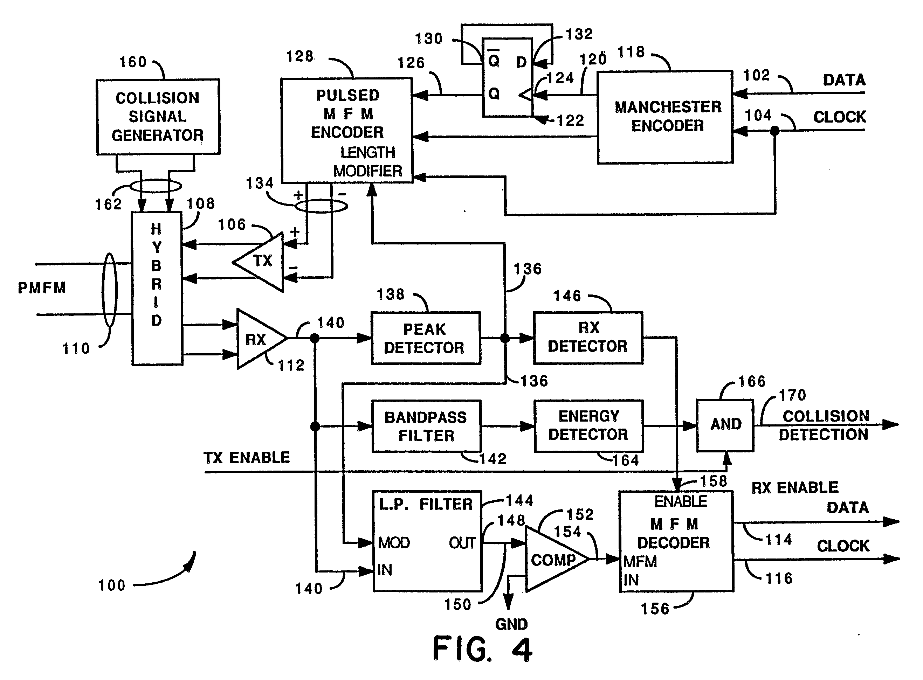

Referring now to Figure 4, there is shown a block diagram illustrating a digital data converter (DDC) circuit 100 for encoding and decoding a PMFM signal in accordance with the invention. The DDC circuit 100 receives raw data on a first data line 102 together with a clock signal on a first clock line 104 and transmits modulated PMFM signals through a three-level driver 104 coupled through a conventional hybrid 108 to a twisted pair line 110. PMFM signals as at least partially degraded by the twisted pair line 110 are received through the hybrid 108 at a receiver circuit 112. Thereafter the received signal is decoded to recover raw data signal and a clock signal on respective output data line 114 and output clock line 116.

The encoder portion of the DDC circuit comprises a Manchester encoder 118 coupled to receive raw data on line 102 and a clock on line 104 and provides as output a Manchester code signal on line 120. According to the invention, the Manchester code on line 120 is coupled to a Manchester to MFM converter 122, which is a D-type flip flop, wherein the input on line 120 is to the clock terminal 124 and wherein the noninverting (Q) output is on line 126 to a pulsed MFM encoder, as hereinafter explained. Further, the inverting (Q_) output 130 is coupled to the data (D) input 132 of the flip-flop 122. By this mechanism, a Manchester code is converted into the MFM code.

The pulsed MFM encoder 128 receives a clock signal via line 104 and an MFM signal via line 126 and provides a differential pulsed MFM code via lines 134 to the driver 106. In accordance with the invention, the length of the pulse is constant, but subject to adjustment by means of, for example, a length modifier signal on line 136. The length modifier signal is generated at the output of a peak detector 138 monitoring the peak signals as received on line 140 from the receiver 112.

The receiver portion of the DDC circuit 100 comprises the receiver 112 having its output on line 140 coupled to the peak detector 138, a bandpass filter 142 and an adjustable low-pass filter 144. The output of the peak detector 138 is coupled, in addition to the PMFM encoder 128, to a receive signal detector 146 (for detecting the presence of received signals), and to an adjustment input of the low-pass filter 144 (for controlling the bandwidth of the low-pass filter 144).

The peak of the received input signal is used to adjust the bandwidth of the low-pass filter 14 such that increasing signal peaks decrease the bandwidth of the low-pass filter. The purpose of the filtering is to remove the effects of the intermediate level on the received signal so that the received signal can be decoded as an MFM signal. The output of the low-pass filter is provided to a comparator 148 via a line 150, which serves as a zero-crossing detector. The output of the comparator 152 is a reconstructed. MFM signal on signal line 154, which is provided to an MFM input of and MFM decoder 156 of conventional design. The MFM encoder 156 is operative to generate as output recovered raw data on line 114 and a recovered co®lock on line 116, when enabled through ·the enable input 158.

Collision signal generation and detection may be optionally provided where the invention is employed in a CSMA/CD (Carrier Sense Multiple Access/Collision Detection) environment, such as an Ethernet-type system. To this end, a collision signal generator 160 may be provided to inject a differential a.c. signal on lines 162 into the hybrid 108. For detection, the bandpass filter 142 having a center frequency intended to pass the collision signal through the receiver 112 has its output coupled to an energy detector 164 (an envelope detector and comparator), the output of which is coupled to an AND gate 166. The AND gate indicates at its output detection of a collision whenever it is enabled by a transmit enable signal on line 168 and a collision signal is present. Output is given on a collision detection line 170.

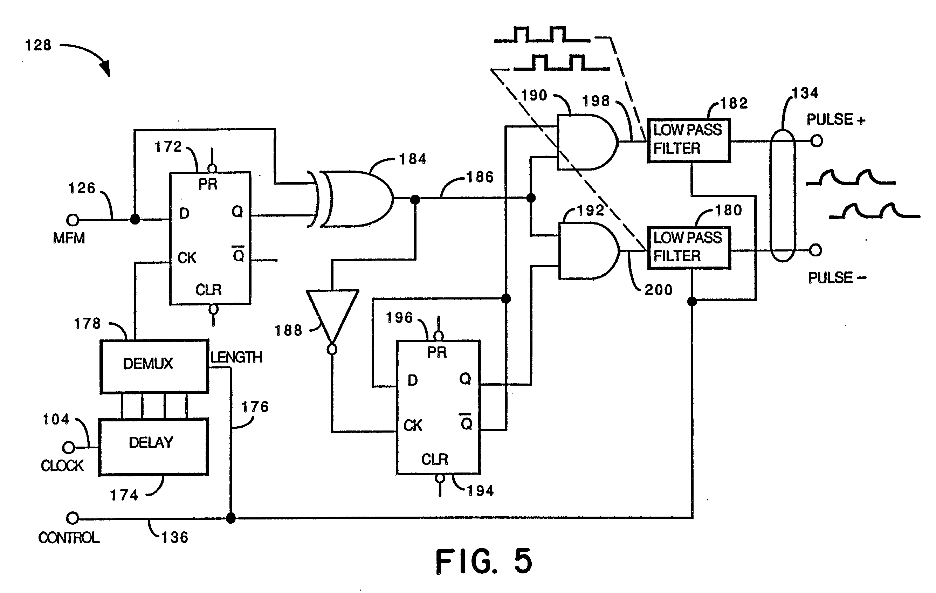

Referring to Figure 5, there is a schematic diagram of a a specific embodiment of pulsed MFM encoder 128 in accordance with the invention. It is to be understood that there are alternative embodiments of such an encoder within the scope of the invention. The MFM input on line 126 is coupled to the Data (D) input of a first D-type flip flop 172 and to a first input of an exclusive-OR gate 184. The clock input on line 104, which is in phase with the MFM input, is coupled to an input of a delay circuit (such as a shift register) 174.

The length modifier signal on line 136 is coupled to a control input 176 of a demultiplexer 178 (such as a cell selector for selecting an output cell in the delay circuit 174). The demultiplexer 178 is thus coupled to the delay circuit 174 for selecting incremental delays of the clock signal on line 104. The length modifier signal on line 136 is also coupled to dual low-pass filters 180 and 182 for use in controlling bandwidth of the filters. The outputs of the low-pass filters 180 and 182 are the differential pulsed MFM signals, which are applied to lines 134, as noted above.

Referring again to the first flip flop 172, the output of the demultiplexer 178 is coupled to the clock input of the first flip flop 172, and the noninverting (Q) output of the first flip flop 172 is coupled to the second input of the exclusive-OR gate 184.

The output of the exclusive-OR gate 184 is couple on a line 186 to an inverter 188, to a first input of a first dual input AND gate 190 and to a first input of a second dual input AND gate 192.

The output of the inverter 188 is coupled to the clock input of a second D-type flip flop 194. The inverting (Q_) output of the second flip flop 194 is coupled to its data (D) input 196 in feedback and to the second input of AND gate 190. The noninverting (Q) output of the second flip flop 194 is coupled to the second input of second AND gate 192.

The output of the first AND gate 190 is coupled via line 198 to the signal input of the first low-pass filter 182, and the output of the second AND gate 192 is coupled via line 200 to the signal input of the second low-pass filter 180.

The pulsed MFM encoder operates as follows: An MFM signal on line 126 is applied to the first input of the exclusive-OR gate 184 and the D input of the first flip flop 172 in phase with a clock signal on line 104. A control signal on line 136 selects a delay to be applied to the clock signal by selecting a length setting of the demultiplexer 178.

Whenever the signal on line 126 is different than the Q output of first flip flop 172, a high signal applied through the exclusive-OR gate is propagated through to the AND gates 190 and 192 and to the clock input of the second flip flop 194. The output of the second flip flop 194 alternates selection of the AND gates 190 and 192 so that the outputs on lines 198 and 200 are alternately active. The duration or length of the alternate active pulses is determined by the delay 174 of the clock signal on line 104. Specifically, the output of the demultiplexer 176 controls the propagation of the signal through the first flip flop to the second input of the exclusive-OR gate 184. When the two inputs are the same, the output on line 186 is low, thus causing either of the AND gates 190 and 192 to generate a low output, if either of the outputs on lines 198 and 200 of the AND gates 190 and 192 are high.

The low-pass filters 180 and 182 are used for shaping the pulse outputs of the AND gates 190 and 192 to cause intersymbol interference. The extent of shaping is a function of the bandwidth of the filters. The bandwidth in a specific embodiment is controlled externally by the same control signal on line 136 which controls pulse length. Optionally the bandwidth can be controlled independently of pulse length. The filters may be conventional active filters with tunable bandwidth.

The invention has now been explained with reference to specific embodiments. Other embodiments will be apparent to those of ordinary skill in the relevant art in view of this specification. Therefore, is not intended that the invention be limited, except as indicated by the appended claims.

## Claims

1. In a digital data communication system having a transmitter, a receiver and a communications medium, a method for modulating signals applied to said communications medium comprising the steps of:
converting a stream of binary digital data to a string of a modified frequency modulated code;
producing a pulse for each transition of said modified frequency modulation code, each said pulse having the same polarity as said transition of said modified frequency modulation code, wherein the length of each said pulse is a constant, to produce a string of pulses alternating about a zero reference; and
applying said string of pulses to a communications medium.

2. The method according to claim 1 wherein each said pulse has a maximum pulse length not exceeding the length of the minimum time between transitions of a modified frequency modulation signal.

3. The method according to claim 2 further including the step of controlling the length of each said pulse in order to regulate intersymbol interference for use in connection with signal detection.

4. The method according to claim 3 further including controlling the bandwidth of said string of pulses for shaping said string of pulses prior to said applying step.

5. The method according to claim 4 further including the step of injecting a collision carrier signal to said communications medium.

6. In a digital data communication system having a transmitter, a receiver and a communications medium, an apparatus for modulating signals applied to said communications medium comprising:

means for converting a stream of binary digital data to a string of a modified frequency modulated code;

means for producing a pulse for each transition of said modified frequency modulation code, each said pulse having the same polarity as said transition of said modified frequency modulation code, wherein the length of each said pulse is a constant, to produce a string of pulses alternating about a zero reference; and

means for applying said string of pulses to a communications medium.

7. The apparatus according to claim 6 wherein each said pulse has a maximum pulse length not exceeding the length of the minimum time between transitions of a modified frequency modulation signal.

8. The apparatus according to claim 7 further including means for controlling length of each said pulse in order to regulate of intersymbol interference for use in connection with signal detection.

9. The apparatus according to claim 8 further including means for controlling the bandwidth of said string of pulses for shaping said string of pulses prior to said applying step.

10. The apparatus according to claim 9 further including means for injecting a collision carrier signal to said communications medium.

FIG. 1

**FIG. 2**

**FIG. 3**

DATA 102
CLOCK 104

MANCHESTER ENCODER 118

132
124 120
122
130

D Q
Q̄ Q̄

PULSED M F M ENCODER 128
LENGTH MODIFIER
126 136
134

TX 106
108

COLLISION SIGNAL GENERATOR 160
H Y B R I D
162
PMFM 110

RX 112
140

PEAK DETECTOR 138
RX DETECTOR 146
136

BANDPASS FILTER 142
ENERGY DETECTOR 164
140

L.P. FILTER 144
MOD IN OUT 148
COMP 150 152 154
GND

TX ENABLE

AND 166
COLLISION DETECTION 170

ENABLE
M F M DECODER 158
MFM IN 156
RX ENABLE
DATA 114
CLOCK 116

100

FIG. 4

FIG. 5